# EUROPÄISCHE PATENTSCHRIFT

(11) **EP 2 936 582 B1**
(45) Veröffentlichungstag und Bekanntmachung des Hinweises auf die Patenterteilung: **04.12.2019**
(21) Anmeldenummer: 13830179.1
(22) Anmeldetag: 20.12.2013
(51) Int. Cl.: H01L 51/52

(54) **VERFAHREN ZUM HERSTELLEN EINES ORGANISCHEN BAUELEMENTES SOWIE ORGANISCHES BAUELEMENT**
METHOD FOR PRODUCING AN ORGANIC COMPONENT AND ORGANIC COMPONENT
PROCÉDÉ DE FABRICATION D'UN COMPOSANT ORGANIQUE ET COMPOSANT ORGANIQUE

(30) Priorität: 21.12.2012 DE 102012113030
(43) Veröffentlichungstag der Anmeldung: 28.10.2015
(73) Patentinhaber: Technische Universität Dresden, 01062 Dresden (DE)
(72) Erfinder: JÄGELER-HOHEISEL, Till, 01097 Dresden (DE); SCHWAB, Tobias, 01219 Dresden (DE); SCHUBERT, Silvio, 97422 Schweinfurt (DE); RIEDE, Moritz, 01099 Dresden (DE); LEO, Karl, 01219 Dresden (DE)
(74) Vertreter: Bittner, Thomas L.
(86) Internationale Anmeldenummer: PCT/DE2013/100435
(87) Internationale Veröffentlichungsnummer: WO 2014/094741

(56) Entgegenhaltungen:
- WO-A1-2011/104936
- JP-A- 2007 123 124
- JP-A- 2012 169 266
- US-A1- 2011 198 636
- HAN S ET AL: "Al:SiO thin films for organic light-emitting diodes", JOURNAL OF APPLIED PHYSICS, AMERICAN INSTITUTE OF PHYSICS, US, Bd. 96, Nr. 1, 1. Juli 2004 (2004-07-01), Seiten 709-714, XP012068043, ISSN: 0021-8979, DOI: 10.1063/1.1751233

## Beschreibung

Die Erfindung betrifft das Gebiet der organischen Bauelemente.

### Hintergrund

Organische Bauelemente in der hier verwendeten Bedeutung sind elektrische Bauelemente, die zum Teil aus organischen, also kohlenstoffhaltigen Molekülen bestehen. Sie können in einer Ausgestaltung über eine Schichtanordnung mit einer Elektrode, einer Gegenelektrode und einem Stapel von organischen Schichten verfügen, wobei der Stapel organischer Schichten zwischen der Elektrode und der Gegenelektrode und in elektrischem Kontakt mit der Elektrode und der Gegenelektrode gebildet ist. Außerdem können organische Bauelemente auch Schichten außerhalb der Elektronen, etwa Schichten zur Lichtein- oder Lichtauskopplung sowie Schutzschichten aufweisen. Solche organische Bauelemente können beispielsweise organische lichtemittierende Dioden (OLED) oder organische Solarzellen sein. Bei beiden handelt es sich um photoaktive organische Bauelemente, die in dem Stapel organischer Schichten eine oder mehrere photoaktive Schichten umfassen. Im Fall der organischen lichtemittierenden Diode dient die photoaktive Schicht dem Erzeugen von Licht, wenn eine Betriebsspannung an die Elektroden angelegt ist. Bei der organischen Solarzelle wird Licht in der photoaktiven Schicht absorbiert und mittels Ladungstrennung in elektrische Energie umgewandelt.

Aus dem Dokument WO 2007/001429 A2 sind Elektroden mit einem gestapelten Schichtaufbau für organische elektronische Bauelemente bekannt.

Das Dokument DE 195 18 668 A1 offenbart ein elektrolumineszierendes Schichtsystem mit einem zwischen zwei mit einer Gleichspannungsquelle verbindbaren Elektroden angeordneten, lichtemittierenden, organischen Material, wobei eine erste Elektrode eine löcherinjizierende Elektrode (Anode) und eine zweite Elektrode eine elektroneninjizierende Elektrode (Kathode) ist. Eine oder beide Elektroden sollen zumindest bereichsweise aus einem Nanomaterial bestehen.

Aus dem Dokument JP 2012 169266 A ist ein Verfahren zum Herstellen eines organischen Bauelements bekannt, bei dem ein Schichtstapel eine Elektrode, eine Gegenelektrode sowie mehrere hierzwischen angeordnete organische Schichten aufweist. Eine Funktionsschicht wird mit Metallpartikeln gebildet. Ein Bauelement ähnlicher Art ist im Dokument JP 2007 123 124 A offenbart.

Im Dokument US 2011/0198636 A1 ist eine organische lichtemittierende Diode beschrieben, bei der zwischen Elektrodenschichten organische Schichten angeordnet sind. Es ist eine Funktionsschicht aus Metallpartikel-Nanoclustern vorgesehen.

Han et al. "(AI:SiO thin films for organic light-emitting diodes", Journal of Applied Physics, American Institute of Physics US, Bd. 96, Nr. 1, 1. Juli 2004, Seiten 709-714) beschreiben eine organische lichtemittierende Diode, bei der eine Schicht aus Metallpartikeln gebildet ist.

Das Dokument WO 2011/104936 A1 offenbart ein Licht emittierendes Element der vorliegenden Erfindung umfasst eine Licht emittierende Schicht, zwei Elektrodenschichten, Farbumwandlungsschichten und eine transparente Schicht. Die Farbumwandlungsschichten und die transparente Elektrodenschicht enthalten feine Partikel aus Metall.

Beim Herstellen solcher oder anderer organischer Bauelemente wird häufig Abscheidung dünner Schichten in einer Vakuumumgebung genutzt. Auch andere Verfahren wie Abscheiden aus Lösung, Sputtern, also ein Schichtabscheiden mit Hilfe ionisierten Trägergases, sind verbreitet.

### Zusammenfassung

Aufgabe der Erfindung ist es, ein Verfahren zum Herstellen eines organischen Bauelementes sowie ein organisches Bauelement anzugeben, mit denen die Betriebseigenschaften des organischen Bauelementes optimiert sind. In Verbindung mit den organischen lichtemittierenden Dioden soll insbesondere eine verbesserte Auskopplung des im Bauelement erzeugten Lichtes erreicht werden.

Diese Aufgabe wird durch ein Verfahren zum Herstellen eines organischen Bauelementes nach dem unabhängigen Anspruch 1 sowie ein organisches Bauelement nach dem unabhängigen Anspruch 9 gelöst. Vorteilhafte Ausgestaltungen sind Gegenstand von abhängigen Unteransprüchen.

Es kann vorgesehen sein, den Schichtstapel für das elektrische organisch Bauelement auf einem Substrat herzustellen.

Die organischen Schichten sind zumindest zum Teil zwischen der Elektrode und der Gegenelektrode und in elektrischem Kontakt mit der Elektrode und der Gegenelektrode hergestellt.

Zum Ausbilden einer Funktionsschicht mit Metallpartikel-Nanoclustern in dem Schichtstapel werden eine Basisschicht aus einem anorganischen Material ausgebildet und dann eine Anordnung von vereinzelten Metallpartikel-Nanoclustern auf der Basisschicht hergestellt. Zum Ausbilden der Funktionsschicht mit Metallpartikel-Nanoclustern in dem Schichtstapel wird die Basisschicht aus einem anorganischen Material hergestellt auf einem darunterliegenden Stapelbereich, welcher wenigstens eine organische Schicht enthält. Auf der Basisschicht wird eine Anordnung von Metallpartikel-Nanoclustern gebildet, die vereinzelt angeordnet sind. Die Basisschicht und die hierauf gebildete Anordnung von vereinzelten Metallpartikel-Nanoclustern sind außerhalb eines Stapelbereiches zwischen der Elektrode und der Gegenelektrode angeordnet.

Die Metallpartikel-Nanocluster können aus einem Metall oder einer Mischung von Metallen (Legierung) bestehen.

Der Schichtstapel kann einen lichtemittierenden Bereich aus organischem Material umfassen, so dass es sich bei dem Bauelement um ein organisches lichtemittierendes Bauelement handelt. Alternativ kann das organische Bauelement als organische Solarzelle hergestellt werden.

Die Flächendichte, der Abstand zwischen vereinzelten Metallpartikel-Nanoclustern und / oder die Partikelgröße auf der Basisschicht lässt sich durch Veränderung der Prozessparameter in einem weiteren Bereich variieren. Somit lassen sich verbesserte Eigenschaften für das Bauteil erreichen.

Die Metallpartikel-Nanocluster auf der Basisschicht können verbesserte Eigenschaften gegenüber Nanoclustern aufweisen, die auf einer darunterliegenden Schicht abgeschieden worden wären.

Größe und / oder Verteilung der Metallpartikel-Nanocluster können von der Rauigkeit und / oder der Strukturierung der unter der Basisschicht liegenden Schicht(en) abhängen.

Größe und / oder Verteilung der Metallpartikel-Nanocluster können von der Rauigkeit und / oder der Strukturierung der Basisschicht abhängen.

Die Metallpartikel-Nanocluster können in unmittelbarer Nähe zu funktionierenden, intrinsischen, organischen Halbleiterschichten hergestellt werden. So kann etwa eine Nahfeldkopplung an die Metallpartikel-Nanocluster erreicht werden. Die Metallpartikel-Nanocluster können in unmittelbarer Nähe zu anderen Funktionsschichten des Schichtstapels hergestellt werden, wobei der minimale Abstand nur durch die Dicke der Basisschicht bestimmt wird.

Auf der Basisschicht mit den hierauf gebildeten Metallpartikel-Nanoclustern kann eine in der Schichtanordnung folgende Schicht hergestellt werden, welche die mittels der Metallpartikel-Nanocluster erzeugten Oberflächenkonturen zumindest teilweise glättet.

Es können komplexe Schichtstapel hergestellt, indem mittels Mehrfachanwendung entsprechender Verfahrensschritte mehrere Funktionsschichten mit Basisschicht und hierauf angeordneten, vereinzelten Metallpartikel-Nanocluster hergestellt werden.

Mittels der Nutzung der einen oder der mehreren Funktionsschichten kann ein gleichbleibendes Farbempfinden unter verschiedenen Betrachtungswinkeln für organische lichtemittierende Dioden erreicht werden.

Eine Verbesserung bei organischen Bauteilen stellt vorrangig die Erhöhung der Energieumwandlungseffizienz dar, allerdings können je nach Anwendungsfall auch andere Eigenschaften wie geringes Gewicht, ansprechende Farbgestaltung, Langlebigkeit, teilweise Transparenz, die Kombination verschiedener Funktionen etwa Solarlampen- oder Verarbeitungseigenschaften ausschlaggebend für eine Verbesserung sein.

In Abhängigkeit von der Art des organischen Bauelementes kann mit Hilfe der vereinzelten Metallpartikel-Nanocluster auf die Betriebseigenschaften des jeweiligen Bauelementes Einfluss genommen werden. Beispielsweise kann die Funktionsschicht als Streu- oder Auskoppelschicht für das im photoaktiven Bereich einer organischen lichtemittierenden Diode erzeugte Licht dienen. Ein weiterer Anwendungsfall ist die Einkopplung von Licht in die Absorberschichten von organischen Solarzellen.

Die aus einem anorganischen Material, welches elektrisch leitend ist, zumindest in sehr dünnen Schichten, hergestellte Basisschicht bildet die Unterlage für die anschließend hierauf herzustellenden Metallpartikel-Nanocluster. Die Vereinzelung der Metallpartikel-Nanocluster bedeutet insbesondere, dass diese voneinander beabstandet sind und insoweit eine Anordnung getrennter Metallpartikel-Nanocluster gebildet ist. Die Metallpartikel-Nanocluster können beispielsweise im Wesentlichen eine ellipsoide Form oder eine Halbdomform aufweisen.

So können die Metallpartikel-Nanocluster beispielsweise in den Schichtstapel eingebracht werden, nachdem die für die Funktion des Bauteils wichtigen Schichten als planare Schichten ausgeführt worden sind. Neu an dem beschrieben Verfahren ist, dass nur moderate Temperaturen zur Herstellung der Metallpartikel-Nanocluster verwendet werden, die die organischen Schichten nicht zerstören. Hervorzuheben ist, dass das beschrieben Verfahren in der beigefügten Ausführungsform ohne den Einsatz von Lösungsmitteln direkt bei der Herstellung des Schichtstapels auskommt.

Das vorgeschlagene Verfahren zum Ausbilden der Funktionsschicht genügt auch den häufig hohen Anforderungen an die Reinheit der verwendeten Materialien bei organischen Bauelementen.

Das beschriebene Verfahren ist kompatibel mit der verbreiteten Prozessierung von Metallen durch Aufdampfen und stellt damit eine Vereinfachung des Produktionsprozesses gegenüber anderen Lösungen dar.

Die vorgeschlagene Herstellung von Metallpartikel-Nanoclustern zeichnet sich gegenüber bekannten Methoden insbesondere auch dadurch aus, das sie schon bei moderaten Temperaturen Metallpartikel-Nanocluster große Metallpartikel-Nanocluster entstehen, deren Streuquerschnitt für Licht größer ist als deren Absorptionsquerschnitt. So können Temperaturen zwischen etwa 30° C und etwa 150° C hierbei vorgesehen sein, vorzugsweise zwischen etwa 60° C und etwa 140° C.

Die Nanocluster auf der Basisschicht können eine verringerte Absorption gegenüber Nanoclustern aufweisen, die auf der darunterliegenden Schicht abgeschieden worden wären.

Die Nanocluster auf der Basisschicht können eine vergrößerte Nah-Feld-Überhöhung gegenüber Nanoclustern aufweisen, die auf der darunter liegenden Schicht abgeschieden worden wären.

Die Nanocluster auf der Basisschicht können eine vergrößerte Reflexion oder je nach Bauteilgestaltung auch Transmission gegenüber Nanoclustern aufweisen, die auf der darunter liegenden Schicht abgeschieden worden wären.

Das Verfahren ermöglicht es, unter sehr gutem Vakuum zu arbeiten. Die Produktionstechnik ist auf große Flächen und großen Stückzahl-Durchsatz skalierbar. In einer Ausführung kann, insbesondere beim Herstellen der Schichtbereiche mit den Metallpartikel-Nanoclustern, eine Ultra-Hochvakuum-Umgebung angewendet werden. Hierbei oder bei anderen Ausgestaltungen kann dies frei von Oxidation durch ein Restgas oder Restgasgemisch erfolgen.

Das Verfahren kann für viele Metalle und Legierungen angewandt werden. Im Fall eines Metalls ist dies vorzugsweise ein reines Metall, welches insbesondere frei von Metalloxidanteilen ist.

Werden die von den Metallpartikel-Nanoclustern auf der Basisschicht erzeugten Oberflächenkonturen durch die hierauf folgende Schicht im Stapel nur teilweise geglättet, so kann es sein, dass die Metallpartikel-Nanocluster aus dieser nachfolgend aufgebrachten Schicht herausstehen (überstehen), was bedeutet, dass das Material der nachfolgenden Schicht im Wesentlichen nur zwischen den Metallpartikel-Nanoclustern aufgebracht ist, ohne diese vollständig einzuschließen. Letzteres kann genutzt werden, um die Oberflächenkonturen vollständig zu glätten mit Hilfe der nachfolgend aufgebrachten Schicht(en).

Die Funktionsschicht mit Metallpartikel-Nanoclustern kann sich auch außerhalb der Elektroden etwa in einer Streu- oder Schutzschicht befinden.

Bei dem organischen Bauelement kann es sich um ein photoaktives Bauelement handeln, bei dem eine oder mehrere photoaktive Schichten im Stapel organischer Schichten gebildet sind. Mit Hilfe der Basisschicht kann für die Metallpartikel-Nanocluster eine Trennung zu der unter der Basisschicht angeordneten Schicht des Stapels hergestellt sein, so dass die physikalischen Eigenschaften der Metallpartikel-Nanocluster insbesondere bei deren Abscheidung im Wesentlichen unabhängig vom Einfluss der unter der Basisschicht angeordneten Schicht(en) der Schichtanordnung sind. Umgekehrt kann die Basisschicht auch dazu genutzt werden die darunterliegenden Schichten vor dem Einfluss der Metallcluster zu schützen. Eine Basisschicht kann etwa Ladungsträger- oder Anregungs-Rekombination an den Metallpartikel-Nanocluster verhindern. Die Basisschicht kann zum Beispiel aus einem Metall oder einem Metalloxid bestehen. Die Basisschicht kann auch mehrschichtig mit Sub-Basisschichten ausgeführt sein.

Die Anordnung von vereinzelten Metallpartikel-Nanoclustern wird auf der Basisschicht hergestellt, indem auf der Basisschicht ein Metallmaterial abgeschieden wird und das abgeschiedene Metallmaterial auf der Basisschicht vereinzelte Nanocluster selbstorganisierend bildet. Clusterbildung erfolgt aufgrund einer Selbstorganisation der zuvor auf der Basisschicht abgeschiedenen Atome und deren Diffusion zu Kristallisationskeimen. Bevorzugt bildet das abgeschiedene Metall eine nicht geschlossene Schicht auf der Basisschicht. Die Ausbildung von Kristallisationskeimen, kann beispielsweise spontan durch das gleichzeitige Zusammentreffen einer ausreichenden Anzahl von Atomen erfolgen. Die Häufigkeit und Verteilung der Kristallisationskeime kann durch die Beweglichkeit der Metallatome an der Grenzfläche zur Basisschicht, die Temperatur und den Eintrag an Metallatomen bestimmt werden. Die Verteilung lässt sich mit Hilfe von Materialparamtern, wie Material der Basisschicht, Art und Zusammensetzung des Metalls und der Umgebung - etwa Lösungsmittel oder Vakuum, aus dem Abgeschieden wird beeinflussen. Die Häufigkeit und Verteilung der Kristallisationskeime lässt sich weiterhin mit Parametern Druck, Temperatur, Abscheiderate und / oder Abscheidewinkel beeinflussen. Die Kristallisationskeime "sammeln" im weiteren Abscheideprozess Metallatome, die sich in einem durch die Diffusion bestimmten Umgebung befinden ein, so dass sich in der Unmittelbaren Nähe der Kristallisationskeime keine weiteren Kristallisationskeime bilden können. So entsteht eine für die organischen Bauelemente vorteilhafte Verteilung vereinzelter Nano-Cluster. Eine erhöhte Prozesstemperatur begünstigt die Diffusion der Metallatome, so dass größere weiter voneinander entfernte Cluster gebildet werden. Ein erhöhter Materialeintrag fördert die spontane Clusterbildung, so dass eine höhere Flächendichte an Clustern erreicht wird. Materialeintrag durch Aufdampfen aus einem Winkel führt zur Abschattung eines Bereiches hinter anfänglich gebildeten Clustern. Silber bildet auf den Materialien V2O5 (Vanadium(V)oxid) und WO3 (Wolframoxid) größere Cluster als Kupfer.

Eine niedrigere Aufdampfrate führt bei V2O5 zu einer Oberflächenstruktur mit mehr Störungen und zu größeren nicht runden Clustern. Die Ausbildung von Kristallisationskeimen kann auch durch verschiedene Maßnahmen künstlich gesteuert werden. So können sich Kristallisationskeime bevorzugt an Korngrenzen, Rauigkeiten oder Störstellen einer Basisschicht bilden. Die Prozessierungsparameter der Basisschicht können zur Strukturierung der Metallpartikel-Nanocluster verwendet werden. So konnte etwa gezeigt werden, dass die Form der Metallpartikel-Nanocluster von der Aufdampfrate der Basisschicht und einer damit zusammenhängenden mehr oder weniger starken Glättung der darunterliegenden Schichten beeinflusst wird.

Es ist auch möglich, die Basisschicht etwa mit lonenbeschuss oder Ätzverfahren zu strukturieren. Zusätzlich kann die Ausbildung von Kristallisationskeimen durch Aufbringen vereinzelter Atome oder Moleküle auf die Basisschicht angeregt werden. Das Wachstum der Metallpartikel-Nanocluster kann auch durch entsprechende Beleuchtung beeinflusst werden.

Die Basisschicht für das Metallmaterial wird mit einer nicht-benetzenden Oberfläche gebildet. Im Fall einer nicht-benetzenden Oberfläche sind üblicherweise die Kohäsionskräfte zwischen den Teilchen des Materials auf der Oberfläche dominierend gegenüber den Adhäsionskräften zwischen dem Material auf der Oberfläche und dem Material, aus dem die Oberfläche besteht.

Eine bevorzugte Weiterbildung sieht vor, dass die Basisschicht mit den hierauf gebildeten Metallpartikel-Nanoclustern benachbart zur Elektrode oder Gegenelektrode gebildet wird. Es kann vorgesehen sein, dass die darunterliegende Schicht, auf der die Basisschicht gebildet wird, als eine photoaktive Schicht hergestellt wird.

Eine Weiterbildung kann vorsehen, dass ein mittlerer Abstand zwischen benachbarten Metallpartikel-Nanoclustern größer als ein mittlerer Durchmesser der Metallpartikel-Nanocluster ist.

Bevorzugt sieht eine Fortbildung vor, dass die Metallpartikel-Nanocluster auf der Basisschicht mit einer Dichte in der Fläche von etwa 0,1 bis etwa 30 Metallpartikel-Nanocluster pro µm² gebildet werden.

Bei einer vorteilhaften Ausgestaltung kann vorgesehen sein, dass die Metallpartikel-Nanocluster auf der Basisschicht mit einem Durchmesser von etwa 30 bis etwa 300 nm gebildet werden. Es kann vorgesehen sein, dass die Metallpartikel-Nanocluster als Streupartikel für sich in der Schichtanordnung ausbreitendes Licht gebildet werden.

Es kann vorgesehen sein, dass der Schichtstapel bei Substrattemperaturen im Bereich von 0°C bis etwa 180°C hergestellt wird. Temperaturen zwischen etwa 30° C und etwa 150° C können vorgesehen sein, vorzugsweise zwischen etwa 60° C und etwa 140° C. Die Metallpartikel-Nanocluster können hierbei unter Beteiligung von Diffusionsprozessen der Metallatome auf der Basisschicht gebildet werden, wobei sich Größe und Verteilung der Metallpartikel-Nanocluster mittels Wahl der Substrattemperatur während dieses Prozesschrittes einstellen lässt.

Bevorzugt ist die Schicht mit den vereinzelten Metallpartikel-Nanoclustern getrennt und beabstandet von beiden Elektroden gebildet. Die Trennung kann mittels einer oder mehrerer Schichten hergestellt sein, die zwischen der Schicht mit den vereinzelten Metallpartikel-Nanoclustern und der jeweiligen Elektrode angeordnet sind.

Es kann weiterhin vorgesehen sein, dass mindestens eine darunterliegende Schicht, auf denen die Basisschicht und die Anordnung von vereinzelten Metallpartikel-Nanoclustern hergestellt werden, eine organische Schicht ist.

Es können auch bisher geschlossenen Schichten zu Nano-Clustern getempert werden.

Es kann vorgesehen sein, dass die Basisschicht mit den hierauf gebildeten Metallpartikel-Nanoclustern eine Deckschicht für die organischen Schichten bildet.

Ein Beispiel das nicht zur Erfindung gehört sieht vor, dass die Basisschicht und die Metallpartikel-Nanocluster innerhalb des Schichtstapels so eingebracht werden, dass die Eigenschaften der darunterliegenden Schichten wenig durch die Rauigkeit dieser Metallpartikel-Nanocluster beeinträchtigt werden.

Eine vorteilhafte Ausführungsform sieht vor, dass die Schicht, die in der Schichtanordnung auf die Basisschicht mit den hierauf angeordneten Metallpartikel-Nanoclustern folgt, aus einem organischen Material hergestellt wird. Es kann vorgesehen sein, dass ein Stapel organischer Schichten auf der Basisschicht mit den hierauf angeordneten Metallpartikel-Nanoclustern gebildet wird.

Es kann vorgesehen sein, dass die Schicht, die in der Schichtanordnung auf die Basisschicht mit den hierauf angeordneten Metallpartikel-Nanoclustern folgt, als eine Ladungsträgertransportschicht hergestellt wird. Die Ladungsträgertransportschicht kann beispielsweise als eine Löcher- oder Elektronentransportschicht hergestellt werden. Auch eine Ladungsträgertransportschicht, in welcher Ladungsträger in Form von Löchern und Elektronen transportiert werden, kann vorgesehen sein.

Ein Beispiel das nicht zur Erfindung gehört sieht vor, dass die Basisschicht und die Metallpartikel-Nanocluster innerhalb des Schichtstapels so eingebracht werden, dass die Eigenschaften der darunterliegenden Schichten durch eine Ladungsträgertransportschicht von der Funktionsschicht getrennt sind.

Ein Beispiel die nicht zur Erfindung gehört sieht vor, dass die Basisschicht und die Metallpartikel-Nanocluster innerhalb des Schichtstapels so eingebracht werden, dass die Funktionsschicht in eine Ladungsträgertransportschicht eingebettet ist.

Bei einer vorteilhaften Ausgestaltung kann vorgesehen sein, dass mit der Schicht, die in der Schichtanordnung auf die Basisschicht mit den hierauf angeordneten Metallpartikel-Nanoclustern folgt, die durch die Metallpartikel-Nanocluster erzeugten Oberflächenkonturen vollständig geglättet werden. Für die auf die Basisschicht mit den Metallpartikel-Nanoclustern folgende Schicht kann so auf der von der Basisschicht abgewandten Seite eine glatte Oberfläche bereitgestellt werden, auf die dann eine oder mehrere weitere Schichten folgen können.

Es kann vorgesehen sein, die auf die Funktionsschicht folgenden Schichten durch die Metallpartikel-Nanocluster zu strukturieren, etwa um einen Oberfläche aufzurauen. Es kann vorgesehen sein, dass die Metallpartikel-Nanocluster genutzt werden, um andere Materialien, die sich bevorzugt an die Metallpartikel-Nanocluster anlagern, zu strukturieren. Es kann vorgesehen sein, die Metallpartikel-Nanocluster zu nutzen, um andere Materialien, die schlecht an den Metallpartikel-Nanocluster haften zu strukturieren.

Es kann vorgesehen sein, dass die Metallpartikel-Nanocluster genutzt werden, um die Abscheidung weiterer Strukturen etwa durch ihre Wirkung als Katalysatoren oder Kristallisationskeime zu erreichen.

Die Basisschicht wird mit einer für Metalle nicht-benetzenden Oberfläche gebildet.

Die Rekombination von Ladungsträgern kann an den Metallpartikel-Nanocluster durch Ladungsträgertransportschichten vermindert werden. Die Rekombination von Anregungszuständen kann an den Metallpartikel-Nanoclustern durch Ladungsträgertransportschichten vermindert werden.

Die Basisschicht kann das Eindiffundieren von Metallatomen in die darunterliegenden organischen Schichten hemmen.

Eine vorteilhafte Ausgestaltung kann vorsehen, dass die selbstorganisierten Metallpartikel-Nanocluster als Kristallisationskeime für weitere Nanostrukturen verwendet werden. Die selbstorganisierten Metallpartikel-Nanocluster können als Katalysatoren für die Abscheidung weiterer Nanostrukturen verwendet werden.

Ein Beispiel das nicht zur Erfindung gehört sieht vor, dass die Basisschicht und die Metallpartikel-Nanocluster innerhalb des Schichtstapels so eingebracht werden, dass die Eigenschaften der darunterliegenden Schichten durch eine Ladungsträgertransportschicht von der Funktionsschicht getrennt sind. Die Basisschicht kann dazu verwendet werden, eine Beschädigung der darunterliegenden organischen Schichten während der Prozessierung des Metalls zu verringern. Eine vorteilhafte Ausgestaltung kann vorsehen, dass die Basisschicht dazu verwendet wird, eine Verschmutzung der darunterliegenden organischen Schichten während der Prozessierung des Metalls zu verringern.

Eine vorteilhafte Ausgestaltung kann vorsehen, dass das Wachstum der Metallpartikel-Nanocluster durch Aufheizen des Substrats auf eine Temperatur, die die organischen Schichten nicht zerstört, gesteuert wird. Das Heizen des Substrates kann erfolgen, so dass die Metallpartikel-Nanocluster sich bilden und vereinzeln.

Eine vorteilhafte Ausgestaltung kann vorsehen, dass das Wachstum der Metallpartikel-Nanocluster durch aufdampfen mit geringen Aufdampfraten <0.1 nm/s, gesteuert wird.

Eine vorteilhafte Ausgestaltung kann vorsehen, dass die Metallpartikel-Nanocluster auf einer Basisschicht von 1nm bis 5nm Dicke hergestellt werden.

Eine vorteilhafte Ausgestaltung kann vorsehen, dass die Basisschicht für das Partikelwachstum aus Di-Vanadium-Penta-Oxid (V2O5) oder Wolfram-Oxid besteht.

Eine vorteilhafte Ausgestaltung kann vorsehen, dass die Metallpartikel-Nanocluster aus Silber, Gold, Kupfer, Aluminium oder Mischungen hieraus ausgeführt ist.

In Verbindung mit dem organischen Bauelement gelten die vorangehenden Ausführungen zu möglichen Ausgestaltungen des Verfahrens zum Herstellen entsprechend.

### Beschreibung von Ausführungsbeispielen

Im Folgenden werden Ausführungsbeispiele unter Bezugnahme auf Figuren einer Zeichnung näher erläutert. Hierbei zeigen:
- Fig. 1: eine schematische Darstellung eines organischen Bauelementes, das nicht zur Erfindung gehört, mit einer Funktionsschicht,
- Fig. 2: eine grafische Darstellung der Elektrolumineszens-Spektren roter organischer Leuchtdioden
- Fig. 3: eine grafische Darstellung der Elektrolumineszens-Spektren grüner organischer Leuchtdioden
- Fig. 4: eine grafische Darstellung des CIE-Farb-Wertes roter organischer Leuchtdioden in Abhängigkeit vom Betrachtungswinkel,
- Fig. 5: eine grafische Darstellung des CIE-Farb-Wertes grüner organischer Leuchtdioden in Abhängigkeit vom Betrachtungswinkel,
- Fig. 6: eine grafische Darstellung der äußeren Quanteneffizienz organischer Leuchtdioden in Abhängigkeit von der Stromdichte,
- Fig. 7: Rasterelektronenmikroskop-Aufnahme der Funktionsschicht mit den Silberpartikel-Nanoclustern in einer organischen Leuchtdiode,
- Fig. 8: eine Darstellung des Höhenprofils der Funktionsschicht gewonnen durch Rasterkraftmikroskopie,
- Fig. 9: eine grafische Darstellung der externen Quanteneffizienz (in %) in Abhängigkeit von der Wellenlänge des eingestrahlten Lichtes für organische Solarzellen,
- Fig. 10: eine grafische Darstellung der wellenlängenabhängigen Absorption für die verschiedenen hergestellten organische Solarzellen mit den Silberpartikel-Nanoclustern,
- Fig. 11: eine Rasterelektronenmikroskopie-Aufnahme für unterschiedlich großen Silberpartikel-Nanocluster sowie deren Verteilung,
- Fig. 12: eine Rasterelektronenmikroskopie-Aufnahme für unterschiedlich große Silberpartikel-Nanocluster sowie deren Verteilung,
- Fig. 13: eine Rasterelektronenmikroskopie-Aufnahme für unterschiedlich große Silberpartikel-Nanocluster sowie deren Verteilung,
- Fig. 14: eine Rasterelektronenmikroskopie-Aufnahme für unterschiedliche große Silberpartikel-Nanocluster sowie deren Verteilung und
- Fig. 15: eine Rasterelektronenmikroskopie-Aufnahme für unterschiedlich große Silberpartikel-Nanocluster sowie deren Verteilung.

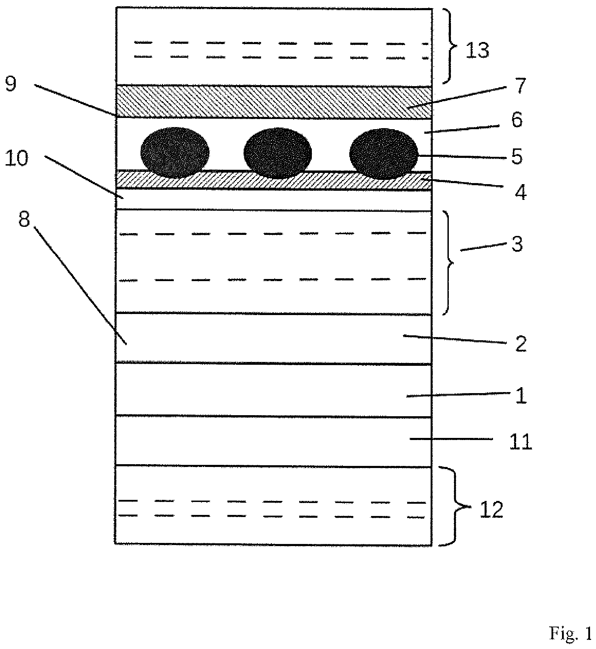

Fig. 1 zeigt eine schematische Darstellung eines organischen Bauelementes das nicht zur Erfindung gehört. Eine Schichtanordnung weist eine Elektrode 1 auf, die beispielsweise aus ITO besteht. Auf die Elektrode 1 ist eine erste Ladungsträgertransportschicht 2 aufgebracht, bei der es sich beispielsweise um eine Elektronentransportschicht handelt. Auf der ersten Ladungsträgertransportschicht 1 ist ein ein- oder mehrschichtig ausgeführter, photoaktiver Bereich 3 angeordnet, auf welchen eine Basisschicht 4 folgt, auf der in einer vereinzelten Anordnung Metallpartikel-Nanocluster 5 angeordnet sind. Die Basisschicht 4 und die Metallpartikel-Nanocluster 5, die zusammen eine Funktionsschicht bilden, werden von einer zweiten Ladungsträgertransportschicht 6 bedeckt, auf die dann eine Gegenelektrode 7 folgt. Letztere besteht beispielsweise aus einem Metall. Zwischen der Elektrode 1 und der Gegenelektrode 7 ist ein Stapel 8 organischer Schichten angeordnet, in welchen beim gezeigten Ausführungsbeispiel die Basisschicht 4 mit den hierauf angeordneten Metallpartikel-Nanoclustern 5 eingebettet ist. Bei der ersten und der zweiten Ladungsträgertransportschicht 2, 6 handelt es sich beispielsweise um eine Elektronentransportschicht sowie eine Löchertransportschicht. Der photoaktive Bereich 3 kann genutzt werden, um das organische Bauelement als organische lichtemittierende Diode oder organische Solarzelle auszubilden. In anderen Ausführungen (nicht dargestellt) können weitere organische Schichten gebildet sein, zum Beispiel Ladungsträgerinjektionsschicht(en) und / oder Blockschicht(en).

Außerdem kann der Schichtstapel auf einem Substrat 11 gebildet sein.

Außerdem kann der Schichtstapel eine weitere Ladungsträgertransportschicht 10 und gegebenenfalls mehrlagige Schichten 12 und / oder 13 außerhalb des Elektrodenpaares 1 und 7 aufweisen, etwa als Schutzschichten oder für die Ein- und Auskopllung von Licht.

Bei der in Fig. 1 gezeigten schematischen Darstellung bedeckt die auf der Basisschicht 4 folgende Schicht eine von den Metallpartikel-Nanoclustern 5 gebildete Oberflächenkontur oderstruktur vollständig, so dass mit der auf die Basissicht 4 folgenden zweiten Ladungsträgertransportschicht 6 eine glatte Oberfläche 9 hergestellt ist, auf der dann die Gegenelektrode 7 abgeschieden ist.

In den Ausführungsbeispielen der Erfindung wird die Basisschicht mit den hierauf gebildeten Metallpartikel-Nanoclustern 5 außerhalb des Stapelbereichs zwischen der Elektrode und der Gegenelektrode angeordnet.

Die in Fig. 1 gezeigte Schichtanordnung kann bei der Herstellung mittels Vakuumabscheidung auf einem Substrat 11 abgeschieden werden, beispielsweise einem Glassubstrat. Die Technologie der Vakuumabscheidung ist als solche in verschiedenen Ausgestaltungen bekannt.

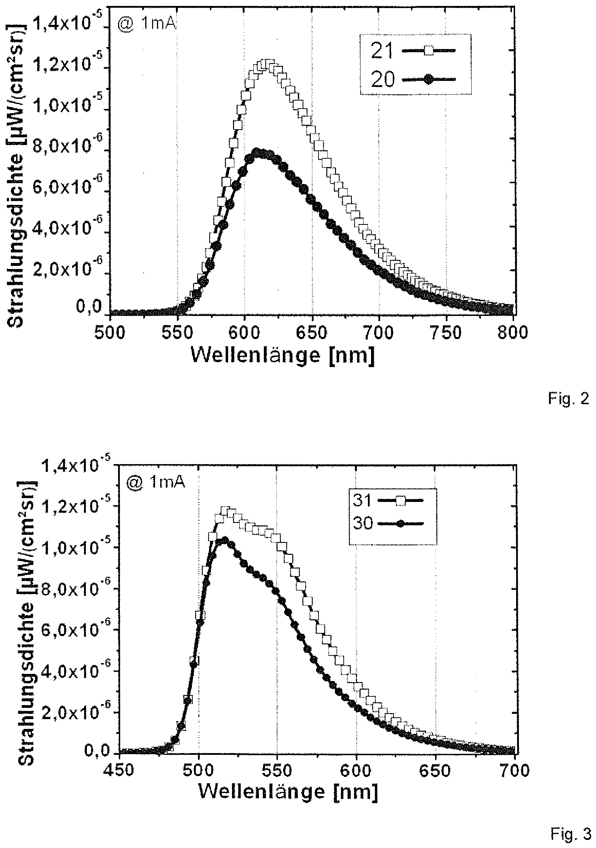

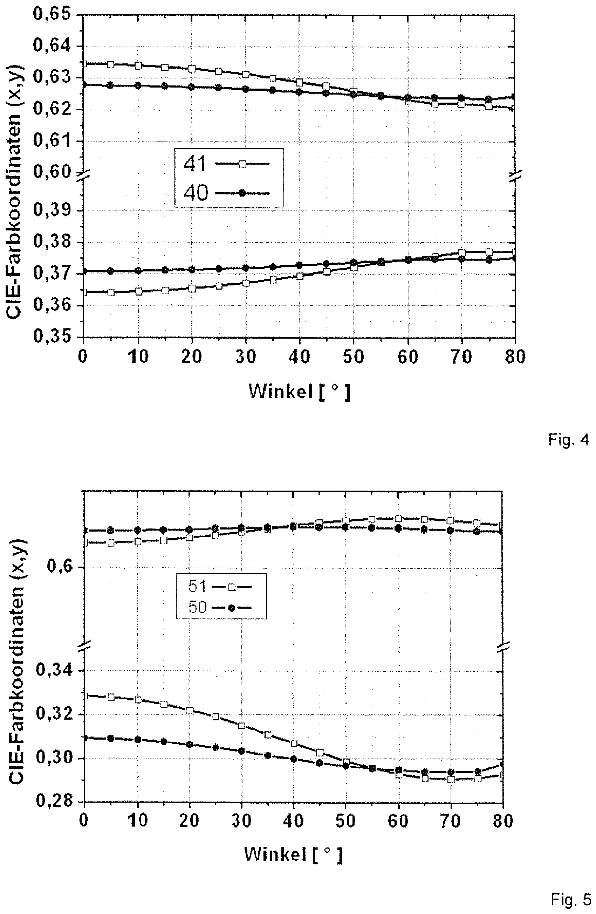

Unter Bezugnahme auf die Fig. 2 und 4 wird nachfolgend ein erstes Beispiel beschrieben, das nicht zur Erfindung gehört. Es wurde eine organische lichtemittierende Diode hergestellt, die rotes Licht, in Richtung eines Substrates, nach "unten", emittiert. Die organische lichtemittierende Diode hat folgenden Schichtaufbau:
- 1.1:: Glassubstrat (Schichtdicke: 1,1 mm)
- 1.2:: ITO (90 nm)
- 1.3:: W2(hpp)4 (1nm)
- 1.4:: BPhen: W2(hpp)4 (10 Gewichtsprozent (wt%)), (73 nm)
- 1.5:: BPhen (10 nm)
- 1.6:: NPD: Ir(MDQ)2(acac) (10 nm), (10 wt%)
- 1.7:: Spiro-TAD (10nm)
- 1.8:: MeO-TPD: F6-TCNNQ (4 wt%), (6nm)
- 1.9:: V2O5 (2nm)
- 1.10:: Ag-Partikel-Nanocluster (3nm - entsprechend einer 3 nm dicken geschlossenen Schicht)
- 1.11:: MeO-TPD: F6-TCNNQ (4 wt%), (55nm)
- 1.12:: F6-TCNNQ (1 nm)
- 1.13:: Al (100 nm)

Die Schicht 1.9 V2O5 wurde mit einer Aufdampfrate von 0,2 Angström pro Sekunde und Schicht 1.10 Ag mit einer Rate von 0,03 Angström pro Sekunde aufgedampft.

Für die Abscheidung der Silberschicht wurde das Substrat auf eine Temperatur von 70°C augeheizt.

Die Dicke der Silberschicht bezieht sich im Folgenden auf eine mit einem Quarzoszillator ermittelte Masse, und beschreibt die Dicke einer Schicht, die im Falle eines homogenen gleichmäßigen Wachstums entstehen würde.

Die Abkürzung "wt%" bezeichnet ein Mischungsverhältniss in Gewichtsprozenten bei der gleichzeitigen Abscheidung zweier Substanzen.

Das Kürzel (1:1) bezeichnet ein Misungsverhältniss von 50 wt%.

Die Angaben in Klammern am Ende der Zeile bezeichnen Schichtdicken.

Hierbei bezeichnen: ITO - Indiumzinnoxid,
W2(hpp)4 - Tetrakis-[1,3,4,6,7,8-hexahydro-2H-pyrimido[1,2-a]pyrimidinato] diwolfram(II),
BPhen - 4,7-Diphenyl-1,10-phenanthrolin,
NPD - N,N'-Di-[(1-naphthyl)-N,N'-diphenyl]-1,1'-biphenyl)-4,4'-diamin,
Ir(MDQ)2(acac) - Iridium(III)bis(2-methyldibenzo-[f,h]chinoxalin)(acetylacetonat) Spiro-TAD - 2,2',7,7'-Tetrakis(N,N-diphenylamino)-9,9'-spirobifluoren,
MeO-TPD - N,N,N',N'-Tetrakis(4-methoxyphenyl)benzidin,
F6-TCNNQ - 2,2'-(Perfluornaphthalen-2,6-diyliden)dimalononitril,
V2O5 - Vanadium(V)-oxid,
Ag -Silber,
Al - Aluuminium

Die organischen Materialien wurden zuvor durch Vakuumsublimation aufgereinigt.

Zum Vergleich wurde ein erstes Referenz-Bauelement, bei dem es sich ebenfalls um eine organische lichtemittierende Diode handelt, wie folgt hergestellt:
- 2.1:: Glassubstrat (1,1 mm)
- 2.2:: ITO (90 nm)
- 2.3:: W2(hpp)4 (1 nm)
- 2.4:: BPhen: W2(hpp)4 (10 wt%) (73 nm)
- 2.5:: BPhen (10 nm)
- 2.6:: NPD: Ir(MDQ)2(acac) (10 wt%) (10 nm)
- 2.7:: Spiro-TAD (10 nm)
- 2.8:: MeO-TPD: F6-TCNNQ (4 wt%) (1nm)
- 2.9:: MeO-TPD: F6-TCNNQ (4 wt%) (65nm)
- 2.10:: F6-TCNNQ (1 nm)
- 2.11:: Al (100 nm)

Fig. 2 zeigt eine grafische Darstellung der wellenlängenabhängigen Strahlungsdichte, des Elektrolumineszens-Spektrums, für die nach "unten", rotes Licht emittierende organische Diode sowie das erste Referenz-Bauelement.

Die Kurven 20 und 21 zeigen die wellenlängenabhängigen Elektrolumineszenz-Spektren der Abstrahlung der roten organischen Leuchtdioden bei einer Abstrahlung senkrecht zur Oberfläche der Leuchtdioden. Die Leuchtdioden werden mit einem Strom von 1mA getrieben und haben eine Fläche von etwa 6,4 mm². Die Strahlungsdichte wurde senkrecht zur Bauteiloberfäche gemessen.

Die Kurve 21, symbolisiert durch weiße Quadrate mit schwarzem Rand, entspricht dem Referenzbauteil ohne V2O5 und ohne Metallpartikel-Nanocluster.

Die Kurven 20, symbolisiert durch schwarze Kreise, entsprichen dem Bauteil mit einer Basisschicht aus V2O5 und Metallpartikel-Nanoclustern, aus Silber.

Fig. 4 zeigt eine grafische Darstellung des CIE-Wertes (nach CIE-Normfarbsystem der Internationalen Beleuchtungskommission) in Abhängigkeit vom Winkel für die rote organische lichtemittierende Diode sowie das erste Referenz-Bauelement. Die Kurven 40 (Kreissymbole) betreffen die rote organische lichtemittierende Diode, mit Funktionsschicht und Metallpartikel-Nanoclustern. Die Kurve 41 (Quadratsymbole) betreffen das erste Referenz-Bauelement. Es ergibt sich eine sehr gute Winkelstabilität für die rote organische lichtemittierende Diode mit Funktionsschicht und Metallpartikel-Nanoclustern.

Unter Bezugnahme auf die Fig. 3 und 5 wird nachfolgend ein weiteres Beispiel, das nicht zur Erfindung gehört, erläutert. Es wurde eine organische lichtemittierende Diode hergestellt, die grünes Licht und in Richtung des Substrats nach "unten" emittiert. Hierbei wurde der folgende Schichtaufbau gewählt:
- 3.1: Glassubstrat (1,1 mm)
- 3.2: ITO (90 nm)
- 3.3: W2(hpp)4 (1 nm)
- 3.4: BPhen: W2(hpp)4 (10 wt%) (51 nm)
- 3.5: BPhen (10 nm)
- 3.6: TCTA: Ir(ppy)3 (8 wt%) (10 nm)
- 3.7: Spiro-TAD (10 nm)
- 3.8: MeO-TPD: F6-TCNNQ (4 wt%) (1nm)
- 3.9: V2O5 (2 nm)
- 3.10: Ag-Partikel-Nanocluster (3 nm, entsprechend einer 3 nm dicken geschlossenen Schicht)
- 3.11: MeO-TPD: F6-TCNNQ (4 wt%) (44nm)
- 3.12: F6-TCNNQ (1 nm)
- 3.13: Al (100 nm)

Die Schicht 3.9 V2O5 wurde mit einer Rate von 0,2 Angström pro Sekunde gedampft. Die Silberschicht 3.10 mit einer Rate von 0,03 Angström pro Sekunde bei einer Substrattemperatur von 70°C.

Hierbei bezeichnen: TCTA - 4,4',4"-Tris(N-carbazolyl)triphenylamin und Ir(ppy)3 - fac-Tris(2-phenylpyridin)iridium. Die Schicht 3.9 V2O5 wurde mit einer Aufdampfrate von 0,2 Angström pro Sekunde und Schicht 3.10 Ag mit einer Rate von 0,03 Angström pro Sekunde aufgedampft. Für die Abscheidung der Silberschicht wurde das Substrat auf eine Temperatur von 70°C aufgeheizt.

Hierzu wurde ein Referenzbauteil mit folgendem Schichtstapel gefertigt, das ebenfalls eine nach "unten" grünes Licht emittierende organische Diode darstellt: Glassubstrat (1,1 nm) / ITO (90 nm) / W2(hpp)4 (1 nm) / BPhen: W2(hpp)4 (10 wt%) (51 nm) / BPhen (10 nm) / TCTA: Ir(ppy)3 (8 wt%) (10 nm) / Spiro-TAD (10 nm) / MeO-TPD: F6-TCNNQ (4 wt%) (49nm) / F6-TCNNQ (1 nm) / Al (100 nm)

Die Fig. 3 zeigt die Strahlungsdichte in Abhängigkeit von der Wellenlänge, das Elektrolumineszensspektrum bei einem Strom von 1mA und einer Bauteilfläche von ca. 6,4 mm². Die Strahlungsdichte wurde senkrecht zur Bauteiloberfäche gemessen.

Die Fig. 5 zeigt den CIE-Wert in Abhängigkeit vom Betrachtungswinkel.

In Fig. 3 betrifft die Kurve 30, symbolisiert durch schwarze Kreise, die grüne organische lichtemittierende Diode mit Funktionsschicht und Metallpartikel-Nanoclustern. Die Kurven 31 ,symbolisiert durch weise Quadrate mit schwarzer Umrandung, betrifft ein Referenzbauteil ohne die Funktionsschicht mit den Silberpartikel-Nanoclustern. In Fig. 5 zeigen die Kurven 50 das Ergebnis für die grüne organische lichtemittierende Diode mit Funktionsschicht und Metallpartikel-Nanoclustern. Die Kurven 51 betreffen das Referenzbauteil.

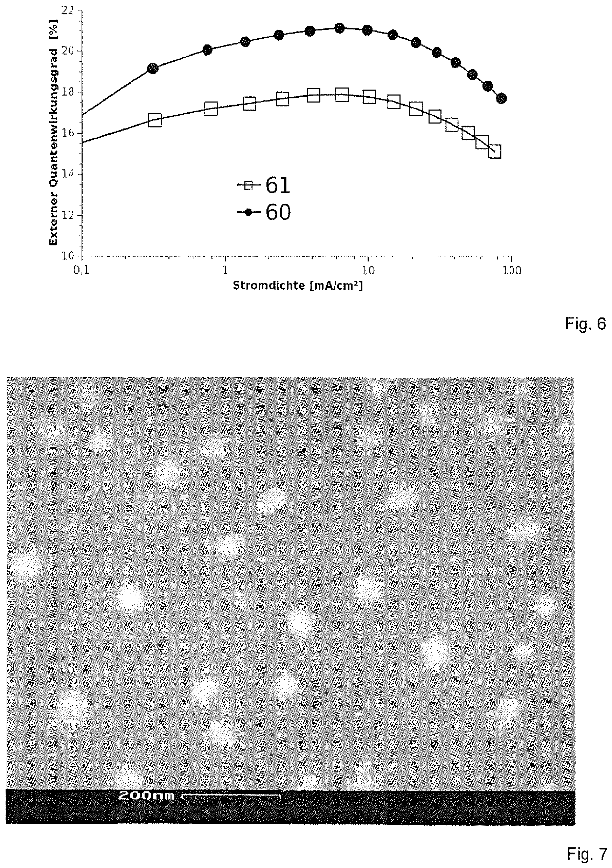

Fig. 7 zeigt eine mittels Rasterelektronenmikroskopie aufgenommene Darstellung einer Funktionsschicht, bei der nach dem Abscheiden von Silberpartikeln auf einer Basisschicht aus V2O5 Silberpartikel-Nanoclustern gebildet wurden. Der Schichtstapel entspricht im Wesentlichen der Anordnung mit den Schichten 3.1 bis 3.13 mit zwei Abweichungen und hat ebenfalls die Funktion einer grünen organischen Leuchtdiode. So wurde die Schicht 3.7b aus Spiro-TAD mit der Dicke von 3nm hergestellt, und die Rasterelektronenaufnahme wurde in einem Bereich der Probe erstellt, an dem kein Aluminium 3.13b abgeschieden wurde. Die Aufnahme wurde mittels eines Sekundärelektronendetektors und eines gescannten fokussierten Elektronenstrahles erstellt, wobei der Schichtstapel senkrecht zu den Schichtebenen projiziert wird. Bereiche die hell erscheinen, enthalten viel Silber. Deutlich lässt sich erkennen, das sich das Silber zu Metallpartikel-Nanoclustern, die beabstandet sind, zusammengelagert hat. Eine generelle Unschärfe der Darstellung entsteht dadurch, dass die Funktionsschicht mit den Metallpartikel-Nanoclustern von weiteren organischen Schichten bedeckt ist.

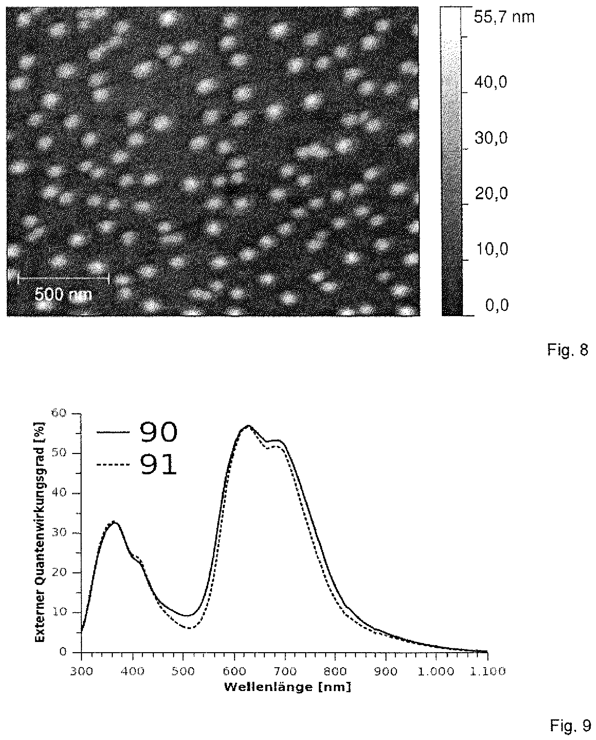

Unter Bezugnahme auf die Fig. 6 und 8 wird nachfolgend ein weiteres Ausführungsbeispiel erläutert. Es wurde eine nach "oben" lichtemittierende organische Diode wie folgt hergestellt:
- 4.1: Substrat
- 4.2: Al (40nm)
- 4.3: Ag (40nm)
- 4.4: MeO-TPD: F6-TCNNQ (4wt %) (36nm)
- 4.5: NPD (10 nm)
- 4.6: NPD: Ir(MDQ)2(acac) (10wt%) (20nm)
- 4.7: BPhen (10nm)
- 4.8: BPhen: Cs (64nm)
- 4.9: Ag (21nm)
- 4.10: V2O5 (2nm)
- 4.11: Ag-Partikel-Nanocluster (3nm)
- 4.12: NPD (77nm)

Zum Vergleich wurde ein weiteres Referenz-Bauteil wie folgt hergestellt:
- 5.1: Substrat
- 5.2: Al (40 nm)
- 5.3: Ag (40 nm)
- 5.4: MeO-TPD: F6-TCNNQ (4 wt%) (36 nm)
- 5.5: NPD (10 nm)
- 5.6: NPD: Ir(MDQ)2(acac) (10wt%) (20 nm)
- 5.7: BPhen (10 nm)
- 5.8: BPhen: Cs (64 nm)
- 5.9: Ag (21 nm)
- 5.10: NPD (82 nm)

Fig. 6 zeigt eine grafische Darstellung der externen Quanteneffizienz (in %) in Abhängigkeit von der Stromdichte für die nach "oben" emittierenden, organischen, lichtemittierenden Dioden. Zur Bestimmung der externen oder äußeren Quanteneffizienz wurde ein Goniometer verwendet, um das winkelabhängige Abstrahlverhalten zu berücksichtigen. Die Kurve 61, symbolisiert durch weiße Quadrate mit schwarzer Umrandung, betrifft das weitere Referenz-Bauteil. Die Kurven 60 wurden für die organische lichtemittierende Diode, mit Funktionsschicht und Metallpartikel-Nanoclustern, gemessen.

Fig. 8 zeigt eine Darstellung des Höhenprofils gewonnen durch Rasterkraftmikroskopie für einen Schichtstapel mit den Schichten 4.1 bis 4.11 (ohne schicht 4.12).

Des Weiteren wurden organische Solarzellen wie folgt hergestellt.

### Solarzelle - Beispiel 1:

- 6.1: Glassubstrat (1,1 nm)
- 6.2: ITO (90 nm)
- 6.3: W2(hpp)4 (1 nm)
- 6.4: C60 (5 nm)
- 6.5: ZnPc: C60 (1:1) (20 nm)
- 6.6: ZnPc (3 nm)
- 6,7: F-DPB: F6-TCNNQ (10 wt%) (2nm)
- 6.8: V2O5 (2 nm)
- 6.9: Ag-Partikel-Nanocluster (3 nm)
- 6.10: BF-DPB: F6-TCNNQ (10 wt%) (55 nm)
- 6.11: F6-TCNNQ (1 nm)
- 6.12: Al (100 nm)

### Solarzelle - Beispiel 2:

- 7.1: Glassubstrat (1,1 nm)
- 7.2: ITO (90 nm)
- 7.3: W2(hpp)4 (1 nm)
- 7.4: C60 (30 nm)
- 7.5: ZnPc: C60 (1:1) (40 nm)
- 7.6: ZnPc (3 nm)
- 7.7: F-DPB: F6-TCNNQ (10 wt%) (2nm)
- 7.8: V2O5 (2 nm)
- 7.9: Ag Nano-Partikel: Ag (3 nm)
- 7.10: BF-DPB: F6-TCNNQ (7 wt%) (55 nm)
- 7.11: F6-TCNNQ (1 nm)
- 7.12: Al (100 nm)

Die Schichten 7.8 V2O5 und 6.8 V2O5 wurde mit einer Rate von 0,2 Angström pro Sekunde gedampft. Die Silberschichten 6.9 und 6.8 mit einer Rate von 0,03 Angström pro Sekunde bei einer Substrattemperatur von 80°C.

### Solarzelle - Beispiel 3:

- 8.1: Glassubstrat (1,1 nm)
- 8.2: ITO (90 nm)
- 8.3: W2(hpp)4 (1 nm)
- 8.4: C60 (30 nm)
- 8.5: ZnPc: C60 (1:1) (40 nm)
- 8.6: ZnPc (3 nm)
- 8.7: F-DPB: F6-TCNNQ (10 wt%) (2nm)
- 8.8: V2O5 (2 nm)
- 8.9: BF-DPB: F6-TCNNQ (7wt%) (55 nm)
- 8.10: F6-TCNNQ (1 nm)
- 8.11: Al (100 nm)

Hierbei bezeichnen: C60 - Fulleren - C60, ZnPc - Zink(II)-phthalocyanin und BF-DPB - N,N'-((Diphenyl-N,N'-bis)9,9,-dimethyl-fluoren-2-yl)-benzidin).

Während die ersten beiden organischen Solarzellen nach den Beispielen 1 und 2 eine Funktionsschicht mit Metallpartikel-Nanoclustern (Silberpartikel) aufweisen, ist dieses für die zuletzt genannte organische Solarzelle nach Beispiel nicht der Fall. Die folgende Tabelle 1 zeigt die für die drei organischen Solarzellen gemessenen Parameter.

**Tabelle 1**

| | Beispiel 3 | Beispiel 2 | Beispiel 1 |
|---|---|---|---|
| Kurzschlussstrom | 9,36 mA/cm² | 10,62 mA/cm² | 9,49 mA/cm² |
| Füllfaktor | 50,9% | 49,1 % | 55,9 % |
| Spannung | 0,51 V | 0,50 V | 0,50 V |
| Effizienz | 2,45 % | 2,61 % | 2,67 % |

Fig. 9 zeigt wellenlängenabhängige externe Quantenwirkungsgrade der Solarzellen entsprechend der Schichtstapel nach Beispiel 2 und Beispiel 3 im Kurzschlussfall. Die durchgezogene Linie 90 entspricht dem Beispiel 2 mit Funktionsschicht und Metallpartikel-Nanoclustern. Die gestrichelte Linie 91 entspricht dem Referenzbauelement Beispiel 3. Durch die Einführung einer Funktionsschicht mit Metallpartikel-Nanoclustern ergibt sich für einen weiten Bereich an Wellenlängen einen erhöhten Quantenwirkungsgrad.

Die Funktionsschicht mit Metallpartikel-Nanoclustern kann auch verwendet werden, um wie in Beispiel 1 effiziente Bauelemente mit dünnen aktiven Schichten zu erzeugen.

Es wurden sodann Untersuchungen zum Prozess der selbstorganisierenden Clusterbildung der auf der jeweiligen Basisschicht abgeschiedenen Metallpartikel durchgeführt. Hierfür werden Schichtstapel 9a bis 9i gezeigt, die im Wesentlichen dem einer organischen Solarzelle entsprechen:
- 9.1: Glas (1,1mm)
- 9.2: ITO (90nm)
- 9.3: W2(hpp)4 (1nm)
- 9.4: C60 : W2(hpp)4 (2wt%) (10nm)
- 9.5: C60 (30nm)
- 9.6: ZnPc : C60 (1:1) (30nm)
- 9.7: ZnPc (5nm)
- 9.8: BF-DPB : F6-TCNNQ (10wt%) (21nm a,b,c,d) (0nm e,f,g,h,i)
- 9.9: V2O5 (2nm a,e,f) (4nm b,c,d,h,i)
- 9.10: Ag (10nm d,i) (5nm c,h) (3nm a,b,f,g) (0nm e)
- 9.11: BF-DPB : F6-TCNNQ (10wt%) (48nm e) (45nm f) (43nm g) (41nm h) (36nm i) (9nm a) (7nm b) (5nm c) (0nm d)
- 9.12: F6-TCNNQ (1nm e,f,g,h,i) (0nm a,b,c,d)
- 9.13: Al (100nm e,f,g,h,i) (0nm a,b,c,d)

Die Basisschicht wurde mittels Vakuumabscheidung mit einer Rate von 0,2 Angström pro Sekunde aus Vanadiumoxid (V2O5) hergestellt. Hierauf wurden dann mittels Vakuumabscheidung mit einer Rate von 0,03 Angström pro Sekunde Silberpartikel abgeschieden. Das Substrat wurde dafür auf 80°C aufgeheizt.

Tabelle 2 zeigt die gefundenen Ergebnisse für unterschiedliche Schichtdicken, mit denen das Silber auf der darunterliegenden Basisschicht aus V2O5 abgeschieden wurde.

**Tabelle 2**

| Schichtstapel | Schichtdicke | Clusterdurchmesser | Clusterhöhe | Aspektverhältnis | Dichte der Cluster pro Fläche |
|---|---|---|---|---|---|
| 9d | 10 nm | 138 nm | 57 nm | 0,41 | 19 / um² |
| 9c | 5 nm | 113 nm | 50 nm | 0,44 | 12 / um² |
| 9b | 3 nm | 100 nm | 40 nm | 0,40 | 12 / um² |
| 9a | 3 nm | 87 nm | 33 nm | 0,38 | 19 / um² |

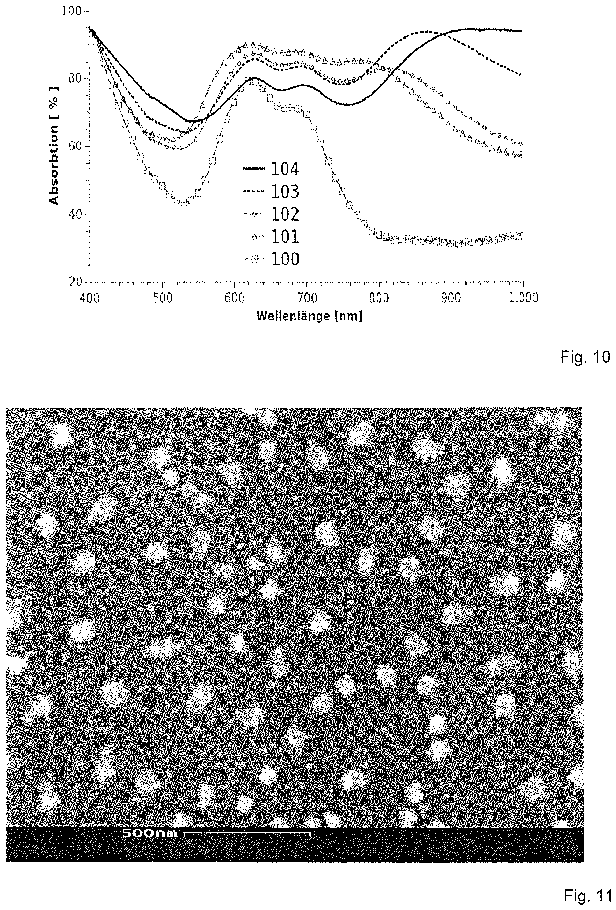

Fig. 10 zeigt eine grafische Darstellung der wellenlängenabhängigen Absorption für die verschiedenen hergestellten Schichtstapel 9f bis 9i mit den Silberpartikel-Nanoclustern, sowie das Referenzbauelement 9e. Die Absorption wurde aus der direkten Reflektion des Bauteils mit einem spiegelnden Rückkontakt bestimmt. Die Kurve 100 zeigt eine Referenzkurve passend zum Schichtstapel 9e für eine Solarzelle ohne Funktionsschicht mit Silberpartikel-Nanoclustern. Die Kurve 101 zeigt das Absorptionsverhalten für die Schichtanordnung, bei der die Silberpartikel-Nanoclustern mit Silbermenge entsprechend einer Höhe von etwa 3 nm und auf einer Basisschicht aus V2O5 mit einer Dicke von 2nm gebildet sind entsprechend dem Schichtstapel 9f. Die Kurven 102, entsprechend 9g, 103, entsprechend 9h und 104 entsprechend 9i betreffen dann Ausführungen, bei denen die Silbermenge einer eine Höhe von etwa 3nm bzw. 5nm sowie 10 nm aufweisen und auf einer Basisschicht mit 4nm Dicke gebildet sind

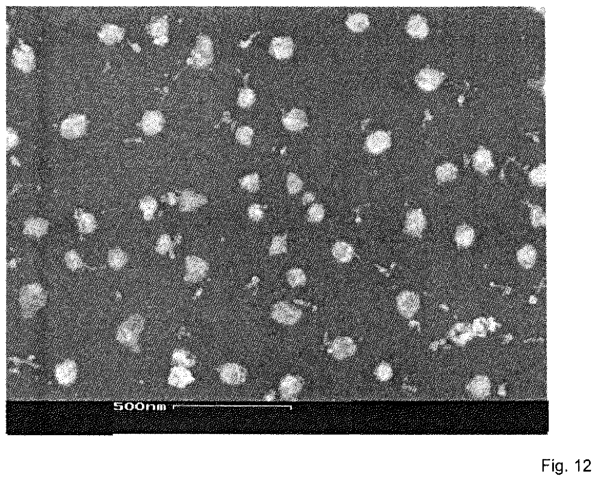

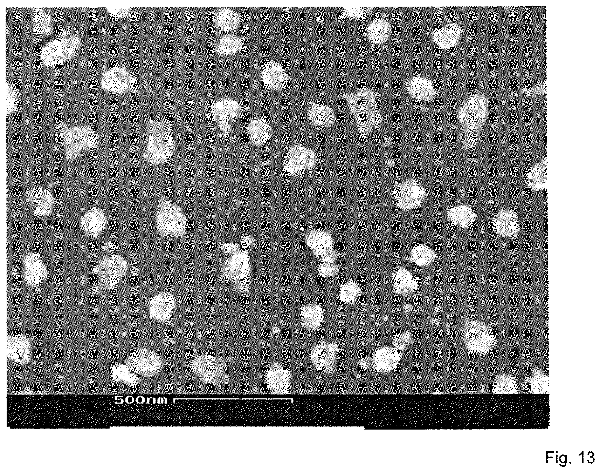

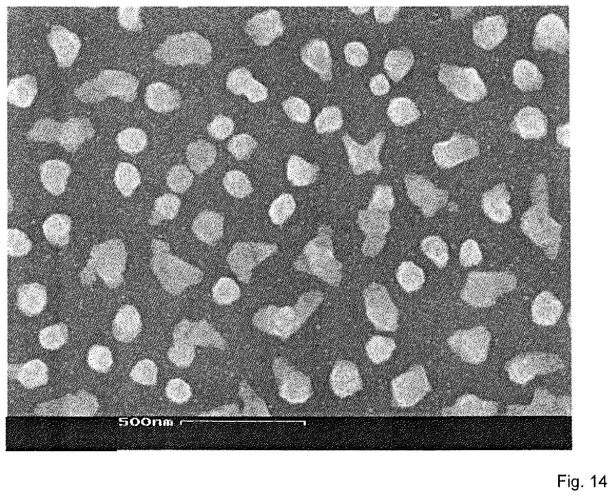

Fig. 11 zeigt eine Rasterelektronenmikroskopie-Aufnahme von Silberpartikel-Nanocluster sowie deren Verteilung für den Schichtstapel 9a. Fig. 12 zeigt eine Rasterelektronenmikroskopie-Aufnahme von Silberpartikel-Nanocluster sowie deren Verteilung für den Schichtstapel 9b. Fig. 13 zeigt eine mittels Rasterelektronenmikroskopie erfasste Aufnahme von Silberpartikel-Nanocluster sowie deren Verteilung für den Schichtstapel 9c. Fig. 14 zeigt eine mittels Rasterelektronenmikroskopie erfasste Aufnahme von Silberpartikel-Nanocluster sowie deren Verteilung für den Schichtstapel 9d.

Die Fig. 7 und 8 wie auch 11 bis 15 enthalten einen weißen Kalibrierungsbalken mit Längenangabe und ermöglichen einen Größenvergleich.

Gemäß Fig. 10 ergibt sich, dass die Absorption in einem großen Wellenlängenbereich durch die Funktionsschicht vergrößert werden kann. Außerdem hängen Größe und Verteilung der Metallpartikel-Nanocluster von der Dicke der Basisschicht ab. Die Bereiche der zusätzlichen Absorption verschieben sich mit größeren Silbermengen entsprechend Fig. 10 und Clusterdurchmessern entsprechend Tabelle 2 zu größeren Wellenlängen.

Die Metallpartikel-Nanocluster aus Fig. 14 (Schichtstapel 9d) zeigen kristalline Bereiche.

Um die Einflüsse der Homogenität der Basisschicht zu untersuchen wurde folgender Schichtstapel untersucht:
- 10.1: Glas (1.1mm)
- 10.2: ITO (90nm)
- 10.3: BPhen : Cs (1:1) (25nm)
- 10.4: BPhen (10nm)
- 10.5: TCTA : Ir(ppy)3 (8wt%) (20nm)
- 10.6: Spiro-TAD (10nm)
- 10.7: MeO-TPD : F6-TCNNQ (4wt%) (30 nm)
- 10.8: V2O5 (2nm)
- 10.9: Ag (4nm)
- 10.10: MeO-TPD : F6-TCNNQ (39nm)
- 10.11: V2O5 (1nm)

Die Schicht 10.8 aus V2O5 wurde mit einer geringeren Rate von 0,1 Angström pro Sekunde gedampft, die Schicht 10.9 aus Silber mit einer Rate von 0,03 Angström pro Sekunde bei einer Substrattemperatur von 70°C.

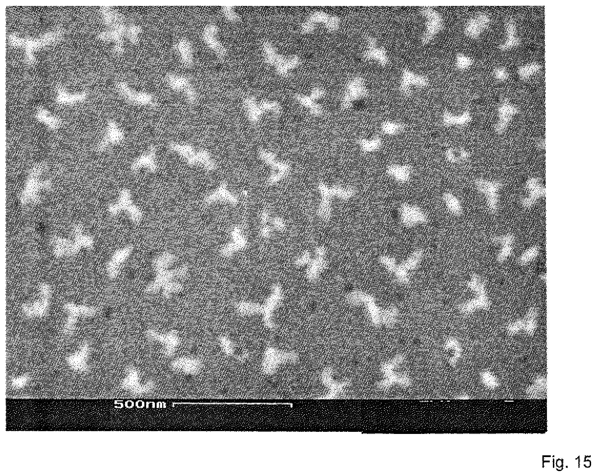

Fig. 15 zeigt eine Rasterelektronenmikroskop-Aufnahme dieses Schichtstapels. Durch die geringe Aufdampfrate der Basisschicht ist diese nicht so homogen. Es sind helle Silberstrukturen, die nicht ellipsenförmig sind, und dunkle Fehlstellen in der Basisschicht zu sehen. Die Struktur der Basisschicht kann genutzt werde, um das Wachstum der Metallpartikel-Nanocluster zu steuern.

Die in der vorstehenden Beschreibung, den Ansprüchen und der Zeichnung offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Verfahren zum Herstellen eines organischen Bauelementes, bei dem ein Schichtstapel mit einer Elektrode (1), einer Gegenelektrode (7) sowie einer oder mehreren organischen Schichten hergestellt wird und bei dem in dem Schichtstapel eine Funktionsschicht mit Metallpartikel-Nanoclustern (5) gebildet wird, wobei hierbei in dem Schichtstapel
- eine Basisschicht (4) aus einem anorganischen Material auf einem darunterliegenden Stapelbereich hergestellt wird, welcher wenigstens eine organische Schicht umfasst, wobei die Basisschicht (4) mit einer für ein Metallmaterial nicht-benetzenden Oberfläche gebildet wird, und
- auf der Basisschicht (4) eine Anordnung von vereinzelten Metallpartikel-Nanoclustern (5) gebildet wird, indem auf der Basisschicht (4) das Metallmaterial abgeschieden wird und das abgeschiedene Metallmaterial auf der Basisschicht (4) vereinzelte Nanocluster selbstorganisierend bildet,
wobei die Basisschicht (4) und die hierauf gebildete Anordnung von vereinzelten Metallpartikel-Nanoclustern (5) außerhalb eines Stapelbereiches (8) zwischen der Elektrode (1) und der Gegenelektrode (7) angeordnet sind.

2. Verfahren nach mindestens einem der vorangehenden Ansprüche, **dadurch gekennzeichnet, dass** die Schicht, die in der Schichtanordnung auf die Basisschicht (4) mit den hierauf angeordneten Metallpartikel-Nanoclustern (5) folgt, aus einem organischen Material hergestellt wird.

3. Verfahren nach mindestens einem der vorangehenden Ansprüche, **dadurch gekennzeichnet, dass** die Basisschicht (4) und die Metallpartikel-Nanocluster (5) im Kontakt zu einer Ladungsträgertransportschicht (6) eingebracht werden.

4. Verfahren nach mindestens einem der vorangehenden Ansprüche, **dadurch gekennzeichnet, dass** ein mittlerer Abstand zwischen benachbarten Metallpartikel-Nanoclustern (5) größer als ein mittlerer Durchmesser der Metallpartikel-Nanocluster (5) ist.

5. Verfahren nach mindestens einem der vorangehenden Ansprüche, **dadurch gekennzeichnet, dass** die Metallpartikel-Nanocluster (5) auf der Basisschicht (4) mit einer Dichte in der Fläche von etwa 0,1 bis etwa 30 Metallpartikel-Nanocluster pro µm² gebildet werden.

6. Verfahren nach mindestens einem der vorangehenden Ansprüche, **dadurch gekennzeichnet, dass** die Metallpartikel-Nanocluster (5) auf der Basisschicht (4) mit einem Durchmesser von etwa 30 nm bis etwa 300 nm gebildet werden.

7. Verfahren nach mindestens einem der vorangehenden Ansprüche, **dadurch gekennzeichnet, dass** der Schichtstapel bei Substrattemperaturen im Bereich von 0 °C bis etwa 180 °C hergestellt wird.

8. Verfahren nach mindestens einem der vorangehenden Ansprüche, **dadurch gekennzeichnet, dass** die Basisschicht (4) und die Anordnung von vereinzelten Metallpartikel-Nanoclustern (5) auf einer organischen Schicht hergestellt werden.

9. Organisches Bauelement, hergestellt nach einem Verfahren nach mindestens einem der vorangehenden Ansprüche, mit einem Schichtstapel, der eine Elektrode (1), eine Gegenelektrode (7) sowie eine oder mehrere organische Schichten aufweist, wobei in dem Schichtstapel eine auf einer Basisschicht (4) gebildete Funktionsschicht mit Metallpartikel-Nanoclustern (5) angeordnet ist, indem auf der Basisschicht (4) ein Metallmaterial abgeschieden wird, **dadurch gekennzeichnet, dass** das abgeschiedene Metallmaterial auf der Basisschicht (4) vereinzelte Nanocluster selbstorganisierend bildet, wobei die Basisschicht (4) mit einer für ein Metallmaterial nicht-benetzenden Oberfläche gebildet wird, und wobei die Basisschicht (4) und die hierauf gebildete Anordnung von vereinzelten Metallpartikel-Nanoclustern (5) außerhalb eines Stapelbereiches (8) zwischen der Elektrode (1) und der Gegenelektrode (7) angeordnet sind.

## Claims

1. A method for manufacturing an organic component, in which a stack of layers with an electrode (1), a counter-electrode (7) as well as one or more organic layers is manufactured, and in which a functional layer with metal particle nanoclusters (5) is formed in the stack of layers, wherein
- a base layer (4) comprised of an inorganic material is manufactured in the stack of layers on an underlying stack area that comprises at least one organic layer, wherein the base layer (4) is formed with a surface that is non-wetting for a metal material, and
- an arrangement of isolated metal particle nanoclusters (5) is formed on the base layer (4) by depositing the metal material on the base layer (4), and the deposited metal material forms isolated nanoclusters on the base layer (4) in a self-organizing manner,
wherein the base layer (4) and the arrangement of isolated metal particle nanoclusters (5) formed hereon is arranged outside of a stack area (8) between the electrode (1) and counter-electrode (7).

2. The method according to at least one of the preceding claims, **characterized in that** the layer that follows the base layer (4) with the metal particle nanoclusters (5) arranged hereon in the layer arrangement is manufactured of an organic material.

3. The method according to at least one of the preceding claims, **characterized in that** the base layer (4) and metal particle nanocluster (5) are introduced in contact with a charge carrier transport layer (6).

4. The method according to at least one of the preceding claims, **characterized in that** an average distance between the adjacent metal particle nanoclusters (5) is greater than an average diameter of the metal particle nanoclusters (5).

5. The method according to at least one of the preceding claims, **characterized in that** the metal particle nanoclusters (5) on the base layer (4) are formed with a surface density of about 0.1 to about 30 metal particle nanoclusters per µm².

6. The method according to at least one of the preceding claims, **characterized in that** the metal particle nanoclusters (5) on the base layer (4) are formed with a diameter of about 30 nm to about 300 nm.

7. The method according to at least one of the preceding claims, **characterized in that** the stack of layers is manufactured at substrate temperatures ranging from 0 °C to about 180 °C.

8. The method according to at least one of the preceding claims, **characterized in that** the base layer (4) and the arrangement of isolated metal particle nanoclusters (5) are manufactured on an organic layer.

9. An organic component manufactured using a method according to at least one of the preceding claims, with a stack of layers, which has an electrode (1), a counter-electrode (7) as well as one or more organic layers, wherein a functional layer with metal particle nanoclusters (5) is arranged in the stack of layers on a base layer (4) by depositing a metal material onto the base layer (4), **characterized in that** the deposited metal material forms isolated nanoclusters on the base layer (4) in a self-organizing manner, wherein the base layer (4) is formed with a surface that is non-wetting for a metal material, and wherein the base layer (4) and the arrangement of isolated metal particle nanoclusters (5) formed hereon is arranged outside of a stack area (8) between the electrode (1) and counter-electrode (7).

## Revendications

1. Procédé pour la fabrication d'un composant organique, dans lequel un empilement de couches est réalisé avec une électrode (1), une contre-électrode (7) ainsi qu'une ou plusieurs couches organiques et dans lequel on réalise, dans l'empilement de couches, une couche fonctionnelle avec des nano-amas de particules métalliques (5), dans lequel, ce faisant, dans l'empilement de couches
- une couche de base (4) est réalisée à partir d'un matériau inorganique sur une zone d'empilement sous-jacente, qui comprend au moins une couche organique, dans lequel la couche de base (4) est réalisée avec une surface non mouillante pour un matériau métallique, et
- sur la couche de base (4), un agencement de nano-amas de particules métalliques (5) isolés est réalisé en ce que le matériau métallique est déposé sur la couche de base (4) et le matériau métallique déposé sur la couche de base (4) forme de manière auto-organisée des nano-amas isolés,
dans lequel la couche de base (4) et l'agencement formé sur celle-ci de nano-amas de particules métalliques (5) isolés sont disposés en-dehors d'une zone d'empilement (8) entre l'électrode (1) et la contre-électrode (7).

2. Procédé selon l'une au moins des revendications précédentes, **caractérisé en ce que** la couche, laquelle, dans l'agencement de couches, suit la couche de base (4) avec les nano-amas de particules métalliques (5) disposés sur celle-ci, est réalisée en un matériau organique.

3. Procédé selon l'une au moins des revendications précédentes, **caractérisé en ce que** la couche de base (4) est les nano-amas de particules métalliques (5) sont insérés en contact avec une couche de transport de porteurs de charge (6).

4. Procédé selon l'une au moins des revendications précédentes, **caractérisé en ce qu'**une distance moyenne entre des nano-amas de particules métalliques (5) voisins est plus grande qu'un diamètre moyen des nano-amas de particules métalliques (5).

5. Procédé selon l'une au moins des revendications précédentes, **caractérisé en ce que** les nano-amas de particules métalliques (5) sur la couche de base (4) sont réalisés avec une densité dans la surface de près de 0,1 à près de 30 nano-amas de particules métalliques par µm².

6. Procédé selon l'une au moins des revendications précédentes, **caractérisé en ce que** les nano-amas de particules métalliques (5) sur la couche de base (4) sont réalisés avec un diamètre de près de 30 nm à près de 300 nm.

7. Procédé selon l'une au moins des revendications précédentes, **caractérisé en ce que** l'empilement de couches est réalisé avec des températures de substrat dans la plage de 0°C à près de 180°C.

8. Procédé selon l'une au moins des revendications précédentes, **caractérisé en ce que** la couche de base (4) et l'agencement de nano-amas de particules métalliques (5) isolés sont réalisés sur une couche organique.

9. Composant organique fabriqué selon un procédé selon l'une au moins des revendications précédentes, avec un empilement de couches qui présente une électrode (1), une contre-électrode (7) ainsi qu'une ou plusieurs couches organiques, dans lequel, dans l'empilement de couches, une couche fonctionnelle avec des nano-amas de particules métalliques (5) formée sur une couche de base (4) est disposée en ce que, sur la couche de base (4), un matériau métallique est déposé,
**caractérisé en ce que** le matériau métallique déposé sur la couche de base (4) forme de manière auto-organisée des nano-amas isolés, dans lequel la couche de base (4) est réalisée avec une surface non mouillante pour un matériau métallique, et dans lequel la couche de base (4) et l'agencement formé sur celle-ci de nano-amas de particules métalliques (5) isolés sont disposés en-dehors d'une zone d'empilement (8) entre l'électrode (1) et la contre-électrode (7).
